# EUROPEAN PATENT APPLICATION

(11) **EP 4 664 461 A1**
(43) Date of publication of application: **17.12.2025**
(21) Application number: 25162535.6
(22) Date of filing: 10.03.2025
(51) Int. Cl.: G11C 16/20, G11C 16/10, G11C 16/04, G11C 29/44, G11C 29/00, G11C 11/56, G11C 7/20

(54) **NON-VOLATILE MEMORY DEVICE HAVING INITIALIZATION INFORMATION BLOCK AND SETTING METHOD THEREOF**

(30) Priority: 14.06.2024 KR 20240077269
(71) Applicant: Samsung Electronics Co., Ltd., Suwon-si, Gyeonggi-do 16677 (KR)
(72) Inventor: LEE, Jaeseok, 16677 Suwon-si, Gyeonggi-do (KR); PARK, Il Han, Suwon-si, Gyeonggi-do 16677 (KR); KIM, Jisu, Suwon-si, Gyeonggi-do 16677 (KR); PARK, Sang-Won, Suwon-si, Gyeonggi-do 16677 (KR)
(74) Representative: Kuhnen & Wacker Patent- und Rechtsanwaltsbüro PartG mbB

(57) **Abstract**

A method of setting an initialization data block (ID_BLK) of a non-volatile memory device includes generating initialization data and a dummy pattern to be programmed into the initialization data block (ID _BLK), programming the initialization data for initializing the nonvolatile memory device into memory cells of first NAND cell strings (NS1-NS3) corresponding to an initialization data area of the initialization data block (ID _BLK), and programming the dummy pattern in memory cells of second NAND cell strings (NS11-NS13, NS21-NS23, NS31-NS33) corresponding to unused areas of the initialization data block (ID _BLK), wherein the memory cell programmed with the dummy pattern is turned off by a read voltage provided to the initialization data block (ID _BLK).

## Description

### BACKGROUND

Semiconductor memory devices can be broadly divided into volatile memory and non-volatile memory. Volatile memory (for example, DRAM or SRAM) has fast reading and writing speeds, but stored data is lost when the power supply is cut off. On the other hand, non-volatile memory can retain stored data even if the power supply is interrupted.

Flash memory devices, a type of non-volatile memory, program memory cells to have a specific threshold voltage to store data. For example, through the programming of the memory cell, electrons are trapped in the nitride film that makes up the memory cell. The threshold voltage level of a memory cell is determined depending on the amount of electrons trapped in the nitride film. For programming memory cells, bias is provided through bit lines, word lines, string selection lines during program operation.

Flash memory devices have information data blocks that store data provided for device initialization. This information data block is also called an initialization data block. The initialization data block is accessed when the flash memory device is booted and provides information for initializing the flash memory device.

### SUMMARY

Some aspects of the present disclosure provide non-volatile memory devices that can reduce peak current or word line loading in an initialization data block, and methods of setting the same. The invention is set out in the appended claims.

According to some implementations, a method of setting an initialization data block of a non-volatile memory device includes generating initialization data and a dummy pattern to be programmed into the initialization data block, programming the initialization data for initializing the nonvolatile memory device into memory cells of first NAND cell strings corresponding to an initialization data area of the initialization data block, and programming the dummy pattern in memory cells of second NAND cell strings corresponding to unused areas of the initialization data block, wherein the memory cell programmed with the dummy pattern is turned off by a read voltage provided to the initialization data block.

According to some implementations, a non-volatile memory device has an initialization data block, the device including main strings each connected to different bit lines by a first string selection line, and unused strings connected to the different bit lines by a second string selection line, wherein initialization data of the non-volatile memory device is stored in the memory cells of the main strings, and a dummy pattern is programmed in the memory cells of the unused strings so that the memory cells are turned off by a read voltage provided to the initialization data block.

According to some implementations, a method of setting an initialization data block of a non-volatile memory device includes generating a dummy pattern to be programmed in an unused area of the initialization data block, and programming the dummy pattern into memory cells of unused NAND cell strings corresponding to the unused area, wherein the memory cell programmed with the dummy pattern is turned off by a word line voltage provided to the initialization data block.

### BRIEF DESCRIPTION OF THE DRAWINGS

The above and other objects and features of the present disclosure will become apparent by describing in detail examples thereof with reference to the accompanying drawings.
FIG. 1 is a block diagram illustrating an example of a non-volatile memory device.
FIG. 2 is a diagram illustrating an example of a structure of the initialization data block ID_BLK shown in FIG. 1.
FIG. 3 is a circuit diagram showing an example of a cell string structure of the initialization data block ID_BLK of FIG. 2.
FIG. 4 is a diagram showing an example of a structure of an initialization data block ID_BLK and an example of a programming method of a dummy pattern.
FIG. 5 is a diagram illustrating a state in which memory cells in an unused area are programmed in dummy pattern.
FIG. 6 is a table showing the channel status of each NAND cell string of the initialization data block ID_BLK during an initialization data read IDR operation.
FIG. 7 shows equivalent circuits that relatively show the magnitude of word line loading during an initialization data read IDR operation of the NAND cell strings of FIG. 6.
FIG. 8 is a table showing the channel status of each string of the initialization data block ID_BLK during a replica read operation.
FIG. 9 is a table showing an example of a dummy pattern DP programmed in an unused area of an initialization data block ID_BLK.
FIG. 10 is a table showing another example of a method of programming a dummy pattern DP for an unused area of an initialization data block ID_BLK.
FIG. 11 is a table showing another example of a method of programming a dummy pattern DP for an unused area of an initialization data block ID_BLK.
FIG. 12 is a block diagram showing an example of a memory system that programs a dummy pattern DP and performs an initialization data read IDR operation.
FIG. 13 is a flowchart showing an example of a programming procedure for initialization data and dummy patterns performed using the memory system of FIG. 12.
FIG. 14 is a flowchart showing an example of a initialization data read IDR method using the memory system of FIG. 12.
FIG. 15 is a block diagram showing an example of a storage system including non-volatile memory devices as described throughout this disclosure.

### DETAILED DESCRIPTION

It is to be understood that both the foregoing general description and the following detailed description disclose examples. Wherever possible, the same reference numbers are used in the description and drawings to refer to the same or like parts.

For purposes of this disclosure, it has been recognized that, when accessing the initialization data block in a flash memory device, channel charge may be filled even in NAND cell strings in which no data is actually stored. This ultimately causes an increase in word line loading. An increase in word line loading leads to an increase in the power required to set up the word line of the flash memory device and an increase in peak current. Some implementations according to the present disclosure provide reduced word line loading in the initialization data block.

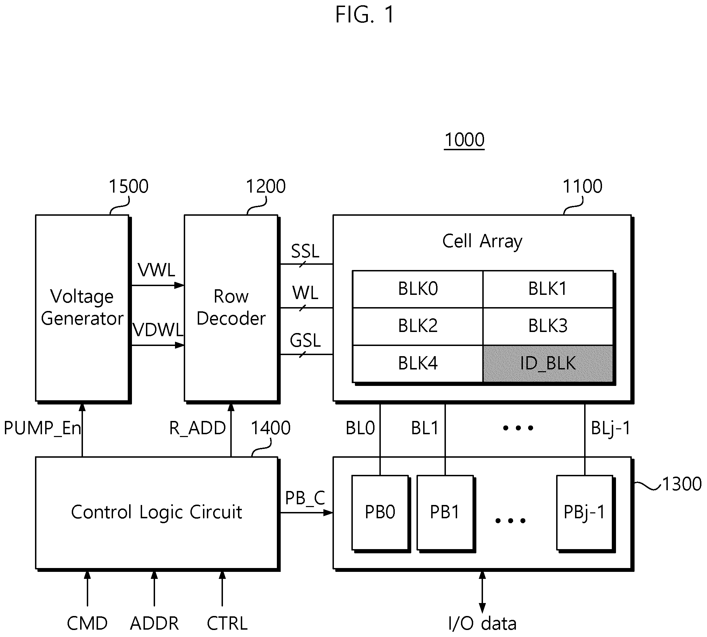

FIG. 1 is a block diagram illustrating a non-volatile memory device according to some implementations of the present disclosure. Referring to FIG. 1, the nonvolatile memory device 1000 includes a cell array 1100, a row decoder 1200, a page buffer circuit 1300, a control logic circuit 1400, and a voltage generator 1500.

The cell array 1100 includes a plurality of memory blocks BLK0, BLK1, BLK2, BLK3, BLK4, and ID_BLK. Each of the plurality of memory blocks may have a three-dimensional structure in which word lines are vertically stacked. Each memory block may include a plurality of pages. Each page may be composed of a plurality of memory cells. Multibit data can be stored in each memory cell. Each memory block is an erase unit, and each page can be a read or write unit. The cell array 1100 may be formed in a direction perpendicular to a surface of a substrate on which the cell array 1100 is disposed. Gate electrode layers and insulation layers may be deposited alternately on the substrate. Each memory block may be connected to the row decoder 1200 through a string selection line SSL, a plurality of word lines, and a ground selection line GSL. The number of stacked gate electrode films on which the word lines of the cell array 1100 are formed increases as product generations advance.

The cell array 1100 has a separate memory block that stores initialization data provided for initialization of the non-volatile memory device 1000. This memory block will hereinafter be referred to as an initialization data block ID_BLK or an information data block ID_BLK. The initialization data block ID_BLK is a memory area hidden from the user. Accordingly, the initialization data block ID_BLK is accessed by the memory controller when the non-volatile memory device 1000 is booted and provides initialization data ID. The size of initialization data ID is relatively small. Therefore, initialization data ID is stored only in some memory areas of the initialization data block ID_BLK, and the remaining areas are left empty. That is, initialization data ID is stored only in memory cells of cell strings connected to some string selection lines SSL of the initialization data block ID_BLK. In some cases, many or most of the memory cells in the cell string exist without data being stored.

When the nonvolatile memory device 1000 is booted or initialized, access to the initialization data block ID_BLK occurs. A word line voltage is provided to read initialization data from the initialization data block ID_BLK. The word lines of the memory block, including the initialization data block (ID_BLK), are shared by all cell strings. At this time, the string selection lines SSL and ground selection lines GLS of the initialization data block ID_BLK will be activated to access some memory areas where initialization data is stored. For example, when a cell string of memory cells in which initialization data is stored is selected, charge may also be supplied to a channel of the cell string of unused memory cells that share the ground selection line GSL. This causes unnecessary charge supply and increased power consumption. In addition, the channel potential of an unused cell string connected to ground by the ground selection line GSL is maintained at the ground level. Therefore, the more cell strings whose channel potential is maintained at ground level, the more power is required to set up the voltage of the word line. That is, word line loading increases. Ultimately, as unnecessary word line loading occurs when accessing the initialization data block ID_BLK, power consumption and peak current increase.

According to some implementations of the present disclosure, in order to reduce word line loading that occurs during an initialization data read IDR operation, a dummy pattern DP is programmed in the initialization data block ID_BLK. For example, the dummy pattern DP is programmed in memory cells (hereinafter referred to as unused memory cells) in which no initialization data of the initialization data block ID_BLK exists. The dummy pattern DP allows at least one memory cell of the string to remain turned off even if the ground selection transistor of the cell string in which initialization data is not stored is turned on. That is, unused memory cells can operate as off-cells by programming the dummy pattern DP. Accordingly, even if the word line voltage is provided and the ground selection transistor is turned on, the channel potential of the unused strings in which the dummy pattern DP is programmed remains disconnected from the ground or the common source line CSL. Accordingly, the channel potential of the unused string programmed with the dummy pattern DP becomes floating when the ground selection line is activated and the word line voltage is supplied. For strings whose channels are set to floating, they contribute little to word line loading to set up the word lines. The initialization data block ID_BLK to which the dummy pattern DP is applied will be described in more detail throughout this disclosure.

The row decoder 1200 may select a word line of the cell array 1100 in response to the row address R_ADD. The row decoder 1200 provides the word line voltage VWL provided from the voltage generator 1500 to the select lines SSL/GSL and word line WL of the memory block selected in the cell array 1100. The row decoder 1200 can select the word line during the program or read operation. The row decoder 1200 may provide a program voltage or a read voltage to the selected word line. These selection line SSL/GSL and word line WL driving operations are equally applied when accessing the initialization data block ID_BLK.

The page buffer circuit 1300 may be connected to the cell array 1100 through bit lines (BL0 to BLj-1, j is a positive integer). The page buffer circuit 1300 may precharge or sense the bit lines BL0 to BLj-1 connected to the memory cells in response to the page buffer control signal PB_C provided from the control logic circuit 1400. The page buffer circuit 1300 may include a plurality of page buffers PB0 to PBj-1. A plurality of page buffers PB0 to PBj-1 may be respectively connected to memory cells through a plurality of bit lines BL0 to BLj-1. The page buffer circuit 1300 may operate as a write driver or a sense amplifier depending on the operation mode.

The control logic circuit 1400 can control various operations within the non-volatile memory device 1000 according to the operation mode. The control logic circuit 1400 may perform program, read, erase operations on the cell array 1100 in response to the control signal CTRL, command CMD, and/or address ADDR. For example, the control logic circuit 1400 may generate a pump enable signal PUMP_En, a page buffer control signal PB_C for program operation. The control logic circuit 1400 provides the pump enable signal PUMP_En to the voltage generator 1500, thereby controlling it to generate the voltage required for read, write, and erase operations.

The voltage generator 1500 may generate a word line voltage VWL required to read or write data in response to the pump enable signal PUMP_En from the control logic circuit 1400. The word line voltage VWL may be provided to a selected word line or an unselected word line through the row decoder 1200. Generally, during the read operation, the read voltage will be applied to the selected word line and a read pass voltage will be applied to the unselected word line. However, the word line voltage VWL is not limited to the voltage applied during the read operation, and may further include voltages depending on operation modes such as program or erase. The voltage generator 1500 may include a charge pump and a word line voltage generator for this purpose.

During the initialization data read IDR operation for the initialization data block ID_BLK, the channel potential of unselected strings may be floated by a dummy pattern program. Accordingly, charges flowing into the non-selected strings can be blocked and the peak current can be reduced. In addition, the size of the word line loading of the initialization data block ID_BLK during the initialization data read IDR operation can be reduced, and the power consumption of the charge pump required to set up the word line voltage VWL can also be reduced.

As such, based on the nonvolatile memory device 1000, the dummy pattern DP is programmed into unused memory cells of the initialization data block ID_BLK. Accordingly, charge inflow into channels of unselected strings or word line loading that occurs during the initialization data read IDR operation of the nonvolatile memory device 1000 can be reduced. Reducing word line loading and channel charge inflow can provide a reduction in power consumption and peak current occurring during the initialization data read IDR operation.

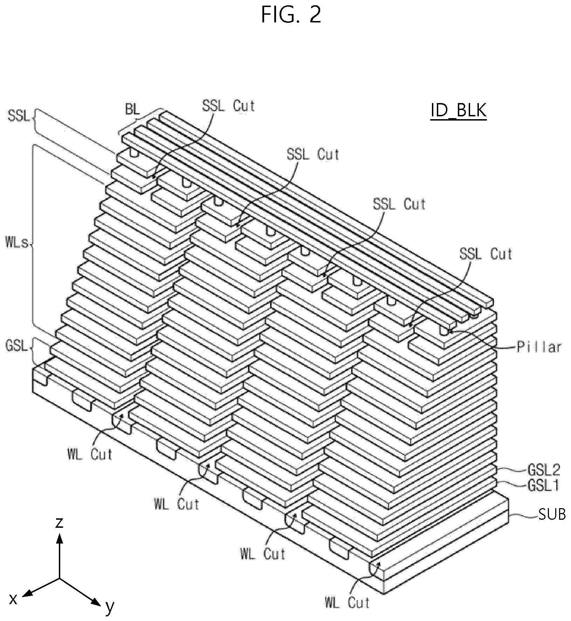

FIG. 2 is a diagram illustrating the structure of the initialization data block ID_BLK shown in FIG. 1. Referring to FIG. 2, conductive layers and insulating layers may be alternately stacked on the substrate SUB to form an initialization data block ID_BLK. The structure of the illustrated initialization data block ID_BLK is equally applicable to the remaining memory blocks (BLK0, BLK1, BLK2, BLK3, and BLK4).

The initialization data block ID_BLK may be formed by stacking at least a ground selection line GSL, a plurality of word lines WL, and at least one string selection line SSL in a plate shape between word line cuts WL Cut on a substrate. Here, at least one string selection line SSL is shown as being separated by a string selection line cut SSL cut. However, it will be understood that this structure is an example and that other structures are within the scope of this disclosure.

Additionally, each word line cut may include a common source line CSL, which is not shown. For example, the common source line CSL included in each word line cut may be connected in common. A pillar connected to the bit line BL penetrates at least one ground selection line GSL, a plurality of word lines WL, and at least one string selection line SSL in the z-direction, so that the NAND cell A string may be formed. Here, the bit lines BL are formed extending in the y-direction. And it is connected to adjacent memory blocks in the y-direction.

As shown, the ground selection line GSL and word line WL plates are separated by a word line cut. However, since the separated word lines are electrically connected for each layer, one layer is formed with one word line. On the other hand, while the ground selection line GSL is separated by a word line cut, each of the separated ground selection lines GSLs can be driven individually. Accordingly, two string selection lines SSL may be allocated to one ground selection line GSL. Memory blocks BLK0, BLK1, BLK2, BLK3, BLK4 into which data is written or read may also be formed in substantially the same structure as the initialization data block ID_BLK.

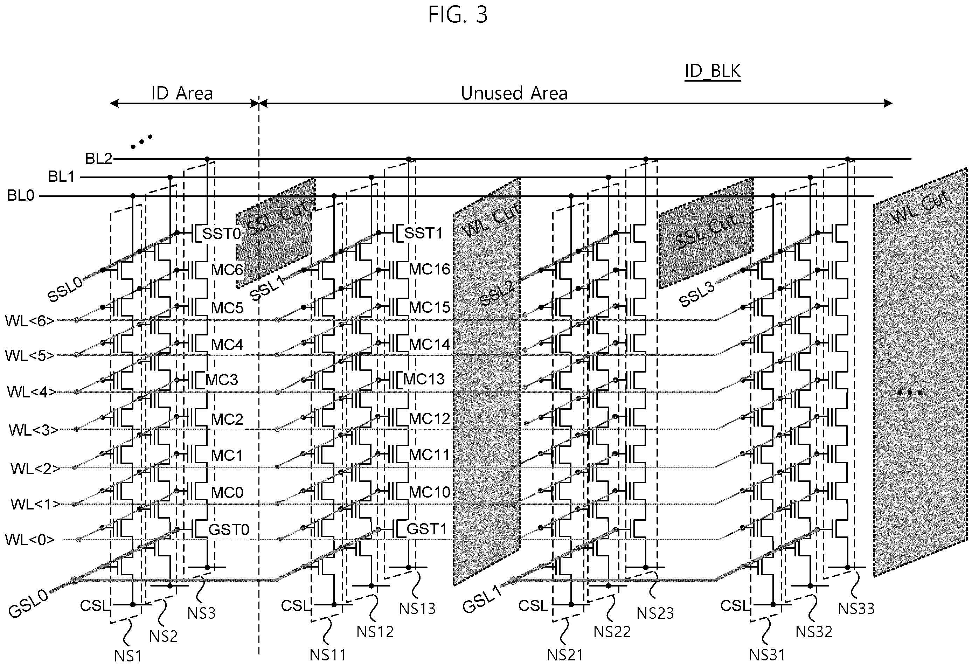

FIG. 3 is a circuit diagram showing the cell string structure of the initialization data block ID_BLK of FIG. 2. Referring to FIG. 3, memory cells (or NAND cell strings) of the initialization data block ID_BLK may be divided into an initialization data area (ID Area) and an unused area (Unused Area). The initialization data area (ID Area) includes memory cells or NAND cell strings in which initialization data is stored. And the unused area (Unused Area) includes memory cells or NAND cell strings that are empty or have a dummy pattern programmed.

NAND cell strings NS1, NS2, and NS3 included in the initialization data area may be selected by the string selection line SSL0 and the ground selection line GSLO. Here, only three bit lines BL0, BL1 and BL2 are shown for convenience, but in some implementations, there may be more bit lines. Accordingly, it will be well understood that there may be more NAND cell strings selected by the string selection line SSL0 and the ground selection line GSLO in the initialization data area. In addition, the NAND cell strings NS1, NS2 and NS3 are shown connected to 7 word lines (WL<0> to WL<6>), but this is only an example for convenience of illustration. In other words, more word lines can be connected to the NAND cell strings NS1, NS2, and NS3. Initialization data ID may be stored in all memory cells constituting the NAND cell strings NS1, NS2, and NS3, but initialization data ID may be stored only in some memory cells. The cell strings NS11, NS12, and NS13 may represent only some of the many cell strings in the initialization data area. Accordingly, the operation of the cell strings NS11, NS12, and NS13 may represent the operation of all cell strings included in the initialization data area.

One NAND cell string NS3 in the initialization data area may include the string selection transistor SST0 connected to a string selection line SSL0, memory cells MC0 to MC6 connected to word lines WL<0> to WL<6>, and a ground selection transistor GST0 connected to the ground selection line GSLO. The number of word lines and the number of selection lines (SSL, GSL) that make up one NAND cell string are simply expressed for convenience of explanation, but it is well known that more word lines and selection lines may be included in practice. All of the NAND cell strings included in the initialization data area will have the same structure as the NAND cell string NS3. During an initialization data read IDR operation that reads initialization data, the selection lines SSL0 and GSLO are activated. Then, as word lines are sequentially selected, initialization data stored in the NAND cell strings NS1, NS2, and NS3 can be read.

On the other hand, the NAND cell strings NS11, NS12, NS13, NS21, NS22, NS23, NS31, NS32 and NS33 included in the unused area of the initialization data block ID_BLK are selected by a plurality of string selection lines (SSL1, SSL2, ..., SSLk). In addition, NAND cell strings NS11, NS12, NS13, NS21, NS22, NS23, NS31, NS32 and NS33) can be selected by ground selection lines (GSLO, GSL1, ..., GSLi-1). One NAND cell string NS13 in the unused area may include the string selection transistor SST1 connected to the string selection line SSL1, memory cells MC10 to MC16 connected to the word lines WL<0> to WL<6>, and a ground selection transistor GST1 connected to the ground selection line GSLO.

Among the NAND cell strings (NS11, NS12, NS13, NS21, NS22, NS23, NS31, NS32, NS33), the NAND cell strings NS11, NS12 and NS13 share the ground selection line GSLO with the NAND cell strings NS1, NS2, and NS3 of the initialization data area. The string selection lines SSL0 and SSL1 may be electrically separated by a string selection line cut (SSL cut), but the ground selection line GSLO may not be separated. Accordingly, when the ground selection line GSLO is activated during an initialization data read IDR operation, the channels of the NAND cell strings NS11, NS12, and NS13 are connected to the common source line CSL or ground. The NAND cell strings NS1, NS2 and NS3 and the NAND cell strings that share the ground selection line GSLO are shown as NAND cell strings NS11, NS12, and NS13 connected to the string select line SSL1. However, the number of strings in the string selection line SSL unit that shares the ground selection line GSLO with the NAND cell strings NS1, NS2, and NS3 may be greater. For example, the initialization data block ID_BLK may be formed in a structure in which NAND cell strings sharing the ground selection line GSLO correspond to the string selection lines SSL0, SSL1, SSL2, and SSL3. In an extreme case, all NAND cell strings of the initialization data block ID_BLK may be formed in a structure in which the ground selection line GSLO is shared.

In this case, during an initialization data read IDR operation, the channel potential is connected to ground according to the activation of the ground selection line GSLO, thereby increasing the number of NAND cell strings in which charge injection occurs. Then, power consumption or peak current may increase as the amount of charge injected into the channel increases during an initialization data read IDR operation. In addition, as the channel potential of the NAND cell strings is maintained at the ground level, the word line setup power due to the capacitance between the word line and the channel will also increase.

However, the memory cells of the NAND cell strings (NS11, NS12, NS13, NS21, S22, NS23, NS31, NS32, NS33) included in the unused area can be programmed with a dummy pattern. Even if the ground selection line GSLO is activated during an initialization data read IDR operation, the connection between the channel and the common source line CSL can be blocked according to the dummy program of the memory cells.

For initialization data read IDR operation, the ground selection line GSLO and string selection line SSL0 will be activated. At this time, the string selection lines SSL1, SSL2, and SSL3 will be deactivated. Accordingly, the channels of the NAND cell strings NS1, NS2, and NS3 in the initialization data area will be connected to the common source line CSL and the bit line. In addition, the NAND cell strings NS11, NS12, and NS13 in the unused area are blocked from the bit line as the string selection line SSL1 is deactivated. However, depending on the activation of the ground selection line GSLO shared with the NAND cell strings NS1, NS2, and NS3, the channels of the NAND cell strings NS11, NS12, and NS13 can be connected to the common source line CSL. The memory cells of the NAND cell strings NS11, NS12, and NS13 are programmed with a dummy pattern DP. Accordingly, even if the word line voltage is provided, the memory cells of the NAND cell strings NS11, NS12, and NS13 may operate as off-cells, thereby blocking the electrical connection between the channel and the common source line CSL.

As such, according to some implementations, peak current and word line loading can be dramatically reduced during an initialization data read IDR operation according to a dummy pattern DP program applied to the unused area of the initialization data block ID_BLK. Accordingly, it is possible to reduce peak current and power consumption generated during an initialization data read IDR operation of the nonvolatile memory device 1000.

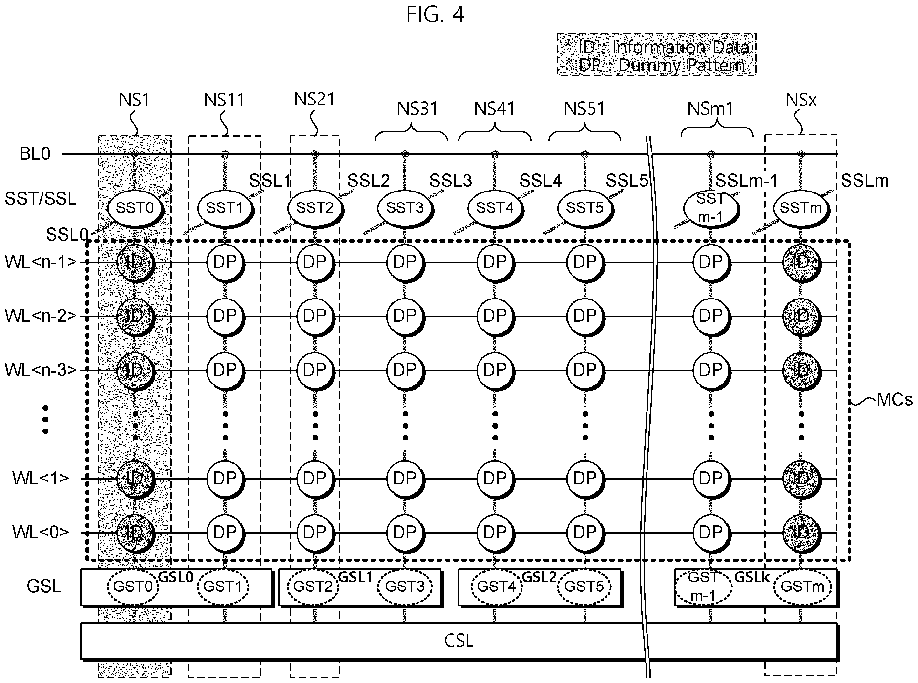

FIG. 4 is a diagram showing the structure of the initialization data block ID_BLK and the programming method of the dummy pattern. Referring to FIG. 4, the program state of memory cells included in NAND cell strings (NS1, NS11, NS21, ..., NSx) connected to one bit line BL0 is shown as an example. However, it will be well understood that the same program scheme can be applied to memory cells of NAND cell strings connected to other bit lines (ex, BL1, BL2, ...).

The NAND cell string NS1 is included in the initialization data area ID Area. The NAND cell string NS1 includes a string selection transistor SST0 that connects to or disconnects from the bit line BL0 by the string selection line SSL0. The NAND cell string NS1 includes a plurality of memory cells MCs connected in series to one end of the string selection transistor SST0 and one end of the ground select transistor GST0. Each of the plurality of memory cells MCs is connected to word lines WL<0> to WL<n-1>. The NAND cell string NS1 includes a ground selection transistor GST0 that electrically connects to or disconnects from the common source line CSL according to the voltage Vgsl of the ground selection line GSLO. The ground selection transistor GST0 is connected to the ground selection line GSLO. And the ground selection line GSLO is also connected to the ground selection transistor GST1 of the NAND cell string NS11 in the unused area. Initialization data ID may be programmed into the memory cells MCs of the NAND cell string NS1.

The NAND cell string NS11 included in the unused area includes a string selection transistor SST1 that performs switching with the bit line BL0 by the string selection line SSL1. The NAND cell string NS11 includes a plurality of memory cells MCs connected in series to one end of the string selection transistor SST1 and one end of the ground select transistor GST1. Each of the plurality of memory cells MCs is connected to word lines WL<0> to WL<n-1>. Like the NAND cell string NS1, the NAND cell string NS11 has a ground selection transistor GST1 that electrically connects or blocks the common source line CSL according to the voltage Vgsl of the ground selection line GSLO. The ground selection transistor GST1 is connected to the ground selection line GSLO like the ground selection transistor GST0 of the NAND cell string NS1. A dummy pattern DP may be programmed into memory cells of the NAND cell string NS11 corresponding to the unused area. For example, the dummy pattern DP may correspond to the highest program state that can be set among program states of memory cells. NAND cell strings NS21,..., NSm1 connected to different string selection lines SSL2 to SSLm-1 may also be set substantially the same as the NAND cell string NS11.

The replica string NSx is used when the initialization data read IDR operation of the NAND cell string NS1 fails. The replica string NSx includes a string selection transistor SSTm that connects to or disconnects from the bit line BL0 by the string select line SSLm. The replica string NSx includes a plurality of memory cells MCs connected in series to one end of the string selection transistor SSTm and one end of the ground select transistor GSTm. Each of the plurality of memory cells MCs is connected to word lines WL<0> to WL<n-1>. The replica string NSx includes a ground selection transistor GSTm that electrically connects to or disconnects from the common source line CSL by the voltage Vgsl of the ground selection line GSLk. The ground select transistor GSTm is connected to the ground selection line GSLk. And the ground selection line GSLm is also connected to the ground selection transistor GSTm-1 of the NAND cell string NSm1 in the unused area. Initialization data ID may be programmed into the memory cells MCs of the replica string NSx. The replica string NSx may be programmed to have the same initialization data ID as the NAND cell string NS1 connected to the same bit line BL0.

During the initialization data read IDR operation, the ground selection line GSLO and the string selection line SSL0 will be activated. At this time, the remaining string selection lines SSL1 to SSLm and ground selection lines GSL1 to GSLk will be deactivated. Accordingly, the channel of the NAND cell string NS1 in the initialization data area will be connected to the common source line CSL and the bit line BL0. In addition, the NAND cell string NS11 in the unused area that shares the ground selection line GSLO is also connected to the common source line CSL according to the turn-on of the ground selection transistor GST1. In addition, the channel of the NAND cell string NS11 may be set to the ground level according to charge injection from the common source line CSL. However, when the word line voltage is provided to the word lines WL<0> to WL<n-1>, the memory cells programmed with the dummy pattern DP of the NAND cell string NS11 may be turned off (Off-cell). In other words, a memory cell programmed with the dummy pattern DP may electrically block the channel from the common source line CSL even if the word line voltage is provided to the word lines of the NAND cell string NS11. Accordingly, during an initialization data read IDR operation, the channel of the NAND cell string NS11 in the unused area sharing the ground selection line GSLO can remain in a floating state. In this case, even if the word line voltage is provided to the word lines WL<0> to WL<n-1>, the channel of the NAND cell string NS11 may be boosted and word line loading may be reduced.

Dummy patterns DP programmed into memory cells of NAND cell strings (NS11, NS21,..., NSm1) included in the unused area may be provided in various ways. In some implementations, regardless of which word line is selected during the initialization data read IDR operation, the channel of the NAND cell string (NS11, NS21,..., NSm1) is floated. To achieve this, all memory cells connected to at least two word lines WL<0> and WL<1> closest to the ground selection lines GSLO to GSLk may be programmed with the dummy pattern DP. In some implementations, all memory cells of the NAND cell strings NS11, NS21,..., NSm1 included in the unused area may be programmed with a dummy pattern DP. In some implementations, memory cells connected to the two word lines WL<0> and WL<1> closest to the ground selection lines GSLO to GSLk and memory cells connected to the two word lines WL<n-2> and WL<n-1> adjacent to the string select lines SSL1 to SSLm-1 may be programmed with a dummy pattern DP. The dummy pattern DP programming method of memory cells in the unused area can be changed in various ways.

In some cases, failure of the initialization data read IDR operation for the initialization data area may occur. At this time, the read operation for the replica string NSx continues. To read the initialization data ID stored in the memory cells of the replica string NSx, the ground selection line GSLk and the string select line SSLm will be activated. At this time, the remaining string selection lines SSL1 to SSLm-1 and ground selection lines GSL1 to GSLk-1 will be deactivated. Accordingly, the channel of the replica string NSx is connected to the common source line CSL and the bit line BL0. And the NAND cell string NSm1 in the unused area that shares the ground selection line GSLk is also connected to the common source line CSL according to the turn-on of the ground selection transistor GSTm-1. In addition, the channel of the NAND cell string NSm1 may be set to the ground level according to charge injection from the common source line CSL. However, when the word line voltage is provided to the word lines WL<0> to WL<n-1>, the memory cells programmed with the dummy pattern DP of the NAND cell string NSm1 may be turned off (Off-cell). A memory cell programmed with a dummy pattern DP electrically blocks the channel from the common source line CSL even if the word line voltage is provided to the NAND cell string NSm1. Therefore, even during the read operation of the replica string NSx, the channel of the NAND cell string NSm1 in the unused area that shares the ground selection line GSLk remains floating. In this case, when the word line voltage is provided to the word lines WL<0> to WL<n-1>, the channel of the NAND cell string NSm1 is boosted, and the word line loading can be relatively reduced.

As explained above, word line loading and peak current can be reduced during initialization data read IDR operation by the dummy pattern DP programmed in the unused area of the initialization data block ID_BLK. Accordingly, it is possible to reduce peak current or power consumption generated during an initialization data read IDR operation of the nonvolatile memory device 1000.

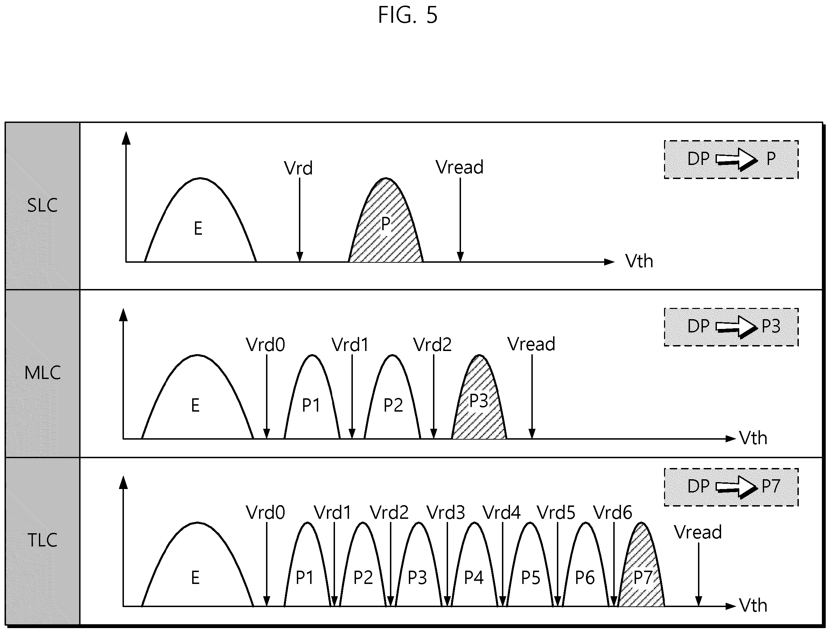

FIG. 5 is a diagram illustrating a state in which memory cells in an unused area are programmed in a dummy pattern. Referring to FIG. 5, the memory cells MCs of the initialization data block ID_BLK are composed of at least one of single-level cell SLC, multi-level cell MLC, triple-level cell TLC, and quad-level cell QLC. The table shown shows a single level cell SLC, a multi-level cell MLC, and a triple level cell TLC as examples. The dummy pattern DP can be defined as the highest state among program states of memory cells.

When the memory cells MCs in the unused area correspond to single level cell SLC, these memory cells MCs have one of the erase state 'E' and the program state 'P'. Memory cells in the unused area may be programmed with a dummy pattern DP. At this time, the dummy pattern DP may be in the program state P in which the memory cell operates as an off-cell with respect to the read voltage Vrd. That is, memory cells in the unused area are programmed in the program state P and operate as off-cells with respect to the read voltage Vrd. While initialization data read IDR operation is performed for the initialization data area, cell strings in the unused area programmed with the dummy pattern DP operate as off-cells by the read voltage Vrd. Accordingly, cell strings may be blocked from the common source line CSL by memory cells programmed with the dummy pattern DP.

When the memory cells MCs of the unused area correspond to multi-level cell MLC, these memory cells MCs can have one state in any of the erase state E and program states P1, P2, and P3. And in order to identify data of a multi-level cell MLC, read voltages Vrd0, Vrd1, Vrd2 and read pass voltage Vread may be provided. The dummy pattern DP written to the memory cells in the unused area may be in the program state P3 in which the memory cell operates as an off-cell with respect to the highest read voltage Vrd2. When memory cells in the unused area are programmed to the highest program state P3, they can operate as off-cells for each of the read voltages Vrd0, Vrd1, and Vrd2. While initialization data read IDR operation is performed for the initialization data area, memory cells programmed with the dummy pattern DP operate as off-cells by the read voltages Vrd0, Vrd1, and Vrd2. Accordingly, cell strings including memory cells programmed with the dummy pattern DP may be blocked from the common source line CSL by the memory cell.

When the memory cells MCs of the unused area correspond to triple level cell TLC, these memory cells MCs can have one state among the erase state E and program states P1, P2, P3, P4, P5, P6, P7. And in order to identify data of a triple level cell TLC, read voltages Vrd0, Vrd1, Vrd2, Vrd3, Vrd4, Vrd5, Vrd6 and read pass voltage Vread may be provided. The dummy pattern DP written to the memory cells in the unused area may be in a program state P7 in which the memory cell operates as an off-cell with respect to the highest read voltage Vrd6. As memory cells in the unused area are programmed to the highest program state P7, they may operate as off-cells with respect to the read voltages Vrd0, Vrd1, Vrd2, Vrd3, Vrd4, Vrd5, and Vrd6. While initialization data read IDR operation is performed for the initialization data area, cell strings in the unused area may be blocked from the common source line CSL by at least one of the read voltages Vrd0, Vrd1, Vrd2, Vrd3, Vrd4, Vrd5, Vrd6.

The dummy pattern DP programming method can also be applied to quad level cell QLC or higher memory cells (not shown) in a similar manner. The unused area of the initialization data block ID_BLK in which the dummy pattern DP is programmed can minimize word line loading during an initialization data read IDR operation. Accordingly, the peak current and power consumption occurring in the initialization data read IDR operation can be reduced by the unused area programmed with the dummy pattern DP.

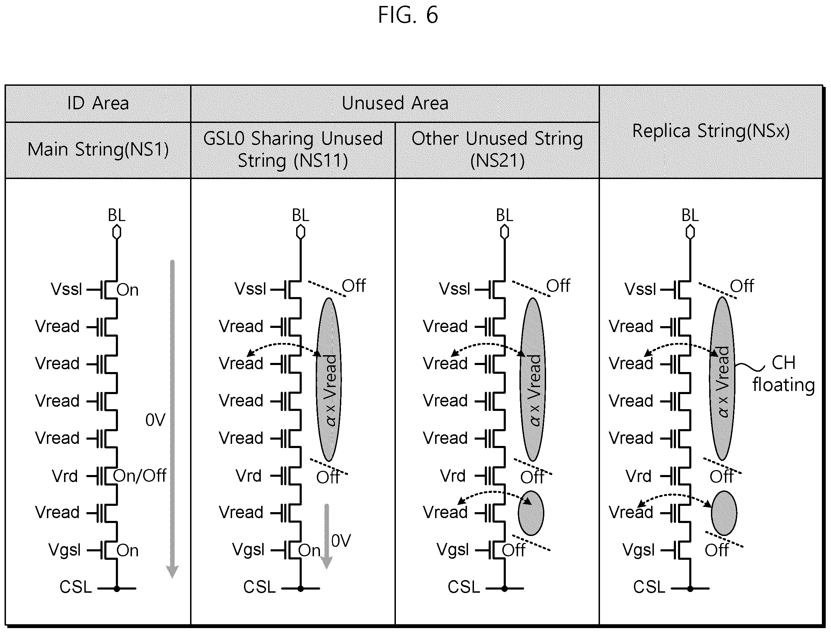

FIG. 6 is a table showing the channel status of each NAND cell string of the initialization data block ID_BLK during an initialization data read IDR operation. Referring to FIG. 6, during an initialization data read IDR operation, a channel state of the main string NS1 in which initialization data ID is stored, unused strings NS11 and NS21 in which a dummy pattern DP is programmed, and a replica string NSx are shown. Here, the unused string NS11 is the NAND cell string that shares the ground selection line GSLO with the main string NS1.

When initialization data read IDR operation starts, the string selection line SSL0 is activated and the remaining string selection lines SSL1 to SSLm are deactivated. Then, only the string selection transistor SST of the main string NS1 is turned on. In addition, the ground selection line GSLO is activated and the remaining ground selection lines GSL1 to GSLk are deactivated. Then, the ground selection transistors GST of the main string NS1 and the unused string NS11 are turned on, and the channels of the main string NS1 and the unused string NS11 are connected to the common source line CSL. Then, a read voltage Vrd is applied to the selected word lines, and a read pass voltage Vread is applied to the unselected word lines.

In the above-described conditions, the channel of the main string NS1 is connected to the bit line BL or the common source line CSL, and the bit line current varies depending on the data (or on-cell/off-cell) of the selected memory cell. Data of the selected memory cell is sensed by detecting changes in charge precharged to the bit line. In initialization data read IDR operation, the channel of the main string NS1 is basically electrically connected to the common source line CSL. Accordingly, charge inflow into the channel of the main string NS1 occurs. And as the channel potential is maintained at the ground level, word line loading occurs depending on the capacity between the word line and the channel.

The channel of the unused string NS11, which shares the main string NS1 and the ground selection line GSLO, may be floated. When the string selection transistor SST1 is turned off due to deactivation of the string selection line SSL1, the electrical connection between the channel of the unused string NS11 and the bit line BL is blocked. And like the main string NS1, the ground selection transistor GST1 of the unused string NS11 is turned on, and the channel of the unused string NS11 is connected to the common source line CSL. However, when the read voltage Vrd is applied to the selected word line and the read pass voltage Vread is applied to the unselected word lines, the memory cell of the unused string NS11 connected to the selected word line operates as an off-cell. This is because the dummy pattern DP is already programmed in the memory cells of the unused string NS11. Even if some memory cells of the unused string NS11 are connected to the common source line CSL, the channel can remain floating due to the memory cells operating as off-cells due to the dummy pattern DP. The floating channel voltage can be raised to the boosting voltage 'α×Vread' by the word line voltage. Therefore, during the initialization data read IDR operation, the unused string NS11, which shares the ground selection line with the main string NS1, can also provide a word line loading reduction effect by programming the dummy pattern DP.

The channel of the unused string NS21, which does not share the ground selection line GSLO with the main string NS1, is floated during an initialization data read IDR operation. As the string selection line SSL2 is deactivated, the string selection transistor SST2 of the unused string NS21 is turned off. Accordingly, the electrical connection between the channel of the unused string NS21 and the bit line BL is blocked. Then, the ground selection transistor GST2 of the unused string NS21 is turned off and the channel of the unused string NS21 is blocked from the common source line CSL. At this time, when the read voltage Vrd is applied to the selected word line and the read pass voltage Vread is applied to the unselected word lines, the memory cell of the unused string NS21 connected to the selected word line operates as an off-cell. This is because a dummy pattern DP is already programmed in the memory cells of the unused string NS21. Since the channel voltage of the unused string NS21 exists in a floating state, it can rise to the boosting voltage 'α×Vread' by the word line voltage. During the initialization data read IDR operation, the unused string NS21 that does not share the ground selection line with the main string NS1 may be floated by blocking the selection transistors SSL2 and GSL2. Accordingly, word line loading in the unused string NS21 can be ignored.

During normal initialization data read IDR operation, the replica string NSx may operate the same as the unused string NS21. This is because, unless a read failure occurs, the selection transistors SSTm and GSTm of the replica string NSx are controlled to turned-off. Therefore, during the initialization data read IDR operation, the channel of the replica string NSx is floating and boosted by the word line voltage. Ultimately, during normal initialization data read IDR operation, word line loading by the replica string NSx can be ignored.

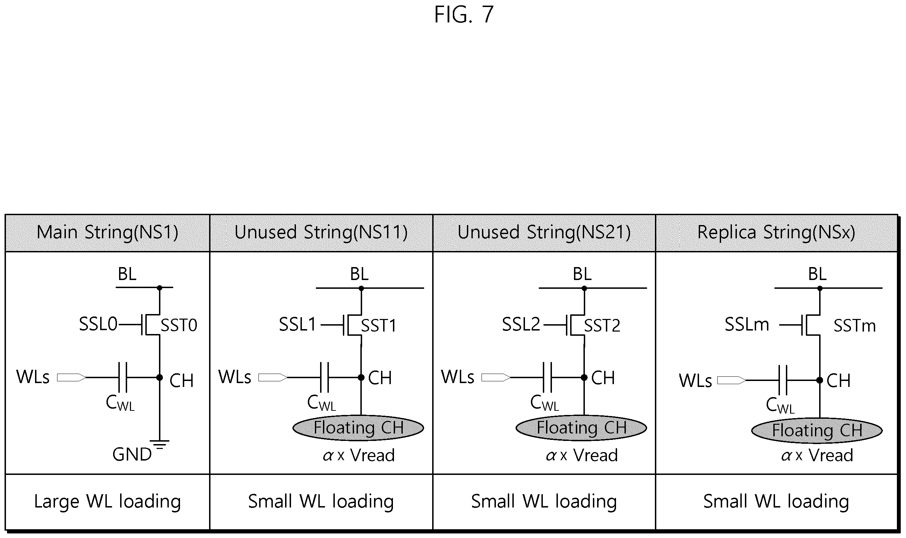

FIG. 7 shows equivalent circuits that show the magnitude of word line loading during an initialization data read IDR operation of the NAND cell strings of FIG. 6. Referring to FIG. 7, based on the programming of the dummy pattern DP, the channels of the remaining NAND cell strings except for the main string NS1 may be maintained in a floating state. Accordingly, word line loading that may occur during an initialization data read IDR operation in the initialization data block ID_BLK can be reduced.

When initialization data read IDR operation starts, the string selection transistor SST0 of the main string NS1 is turned on. And when the ground selection line GSLO is activated, the channel CH of the main string NS1 is connected to the common source line CSL. Accordingly, the channel CH of the main string NS1 is connected to the ground GND corresponding to the potential of the common source line CSL. And the read voltage Vrd and the read pass voltage Vread are applied to the word lines. At this time, a relatively large load occurs in setting up the word line voltage due to the capacitance CWL between the word lines and the channel.

On the other hand, the channel CH of the unused string NS11 may be floated. When the string selection transistor SST1 is turned off due to deactivation of the string selection line SSL 1, the unused string NS11 and the bit line BL are electrically blocked. And the ground selection transistor GST1 of the unused string NS11 may be turned on. However, when the read voltage Vrd and the read pass voltage Vread are applied to the word lines, the memory cell connected to the selected word line operates as an off-cell by programming the dummy pattern DP. Accordingly, the channel CH of the unused string NS11 can remain in a floating state. The floating channel voltage can be raised to the boosting voltage 'α×Vread' by the word line voltage. The word line loading of the unused string NS11 is reduced by the boosted channel potential.

In the case of the unused string NS21, the channel CH of the unused string NS21 is electrically disconnected from the bit line BL and the common source line CSL according to the deactivation of the string selection line SSL2 and the ground selection line GSL2. Accordingly, the channel CH of the unused string NS21 maintains the floating state, and the floating channel voltage can rise to the boosting voltage 'α×Vread' by the word line voltage. Due to the boosted channel potential, the word line loading of the unused string NS21 is reduced to a negligible level.

During normal initialization data read IDR operation, the replica string NSx may operate the same as the unused string NS21. This is because, unless a read fail occurs, the selection transistors (SSTm, GSTm) of the replica string NSx are controlled to turn off. Therefore, during an initialization data read IDR operation, the channel of the replica string NSx is floating, and the floating channel voltage can be increased to the boosting voltage 'α×Vread' by the word line voltage. The word line loading of the replica string NSx can be ignored due to the boosted channel potential.

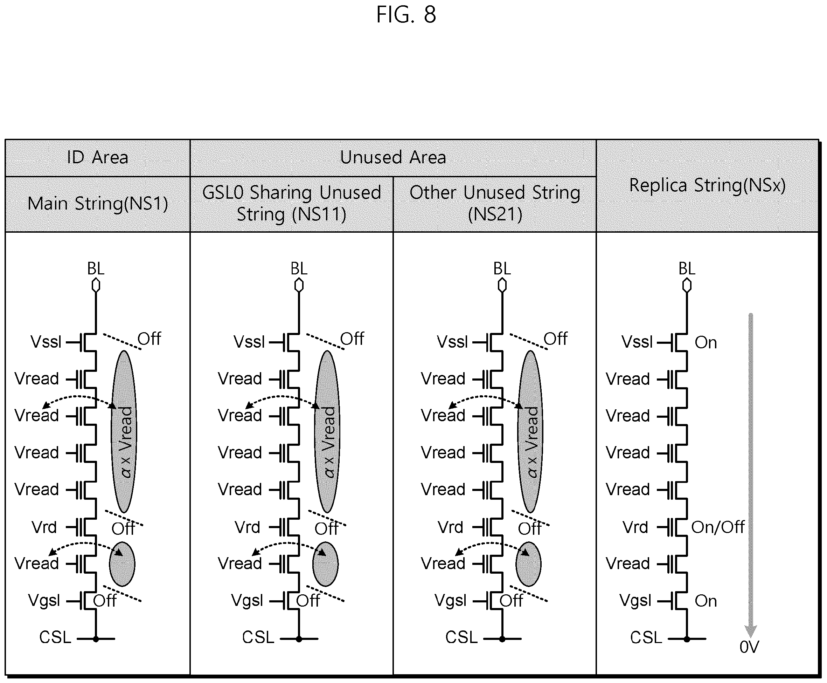

FIG. 8 is a table showing the channel status of each string of the initialization data block ID_BLK during a replica read operation. Referring to FIG. 8, if a read failure of the main string NS1 occurs during an initialization data read IDR operation, the replica read operation for reading data of the replica string NSx follows. During the replica read operation for the replica string NSx, the string selection line of the main string NS1 may be activated or deactivated.

When the replica read operation begins, only the string selection line SSLm is activated and the remaining string selection lines SSL0 to SSLm-1 are deactivated. Then, only the string selection transistor SSTm of the replica string NSx is turned on. In addition, the ground selection line GSLm is also activated and the remaining ground selection lines GSLO to GSLm-1 are deactivated. Then, the ground selection transistor GSTm of the replica string NSx is turned on and the channel of the replica string NSx is connected to the common source line CSL. On the other hand, the channels of the main string NS1 and unused strings NS11 and NS21 are blocked from the common source line CSL. Accordingly, the channels of the main string NS1 and the unused strings NS11 and NS21 are floated. Then, a read voltage Vrd will be applied to the selected word lines, and a read pass voltage Vread will be applied to the unselected word lines.

Under the above-described conditions, the channels of the replica string NSx are connected to the bit line BL or the common source line CSL, and the bit line current varies depending on the data (or on-cell/off-cell) of the selected memory cell. Data from the selected memory cell is sensed by detecting changes in charge precharged to the bit line. In initialization data read IDR operation, the channel of the replica string NSx is effectively electrically connected to the common source line CSL. Accordingly, charge flows into the channels of the replica string NSx and the main string NS1. And as the channel potential of the replica string NSx is maintained at the ground level, relatively larger word line loading than the remaining NAND cell strings occurs depending on the capacitance between the word line and the channel.

The channels of the main string NS1 and unused strings NS11 and NS21 are floated during an initialization data read IDR operation. At this time, when the read voltage Vrd is applied to the selected word line and the read pass voltage Vread is applied to the unselected word lines, the memory cell of the unused string NS21 connected to the selected word line operates as an off-cell. Since the channels of the main string NS1 and the unused strings NS11 and NS21 are in a floating state, the channel voltage can be increased to the boosting voltage 'α×Vread' by the word line voltage. Therefore, during the initialization data read IDR operation, word line loading in the main string NS1 and unused strings NS11 and NS21 can be reduced, e.g., to effectively negligible levels.

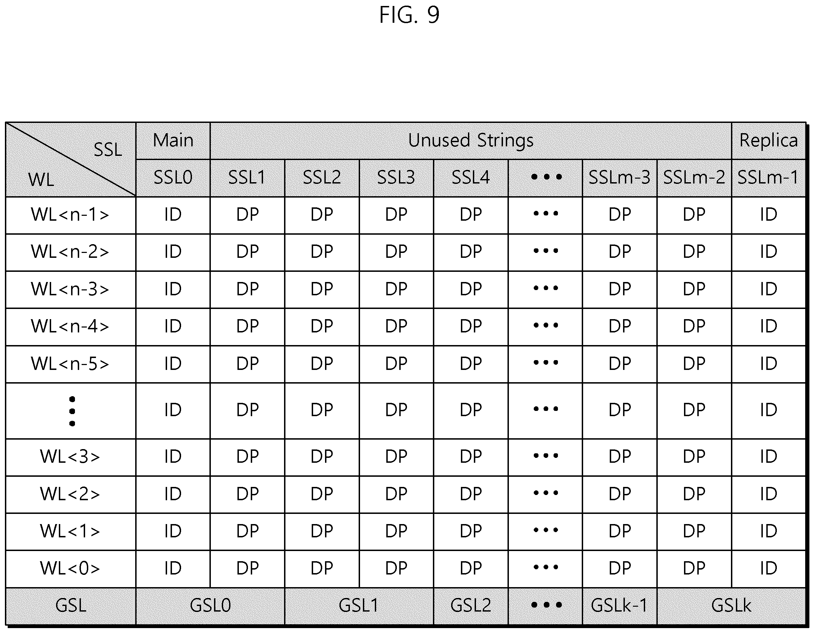

FIG. 9 is a table showing an example of a dummy pattern DP programmed in an unused area of an initialization data block ID_BLK. Referring to FIG. 9, initialization data ID may be stored in memory cells of the main string and replica string, and a dummy pattern DP may be programmed in memory cells of unused strings.

As the dummy pattern DP is programmed in the memory cells of all unused strings, word line loading can be reduced during an initialization data read IDR operation for the main string or a replica read operation for the replica string. In this case, the size of the floating channel of unused strings may change somewhat depending on the position of the selected word line, but the size of word line loading caused by unused strings can be sufficiently reduced.

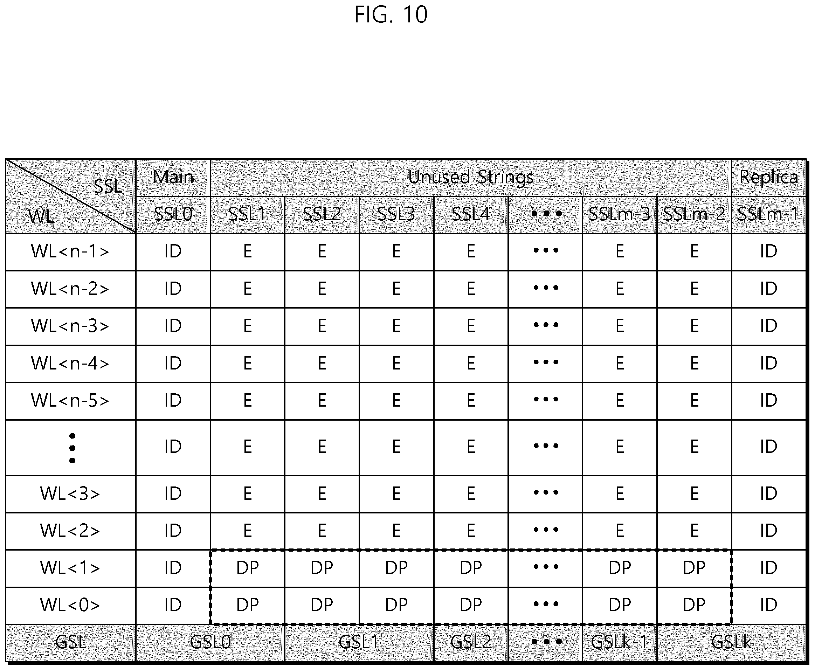

FIG. 10 is a table showing another example of a method of programming a dummy pattern DP for an unused area of an initialization data block ID_BLK. Referring to FIG. 10, initialization data ID is stored in memory cells of the main string and replica string, and the dummy pattern DP may be programmed only in some of the memory cells of the unused strings. At this time, the dummy pattern DP can be programmed only to memory cells connected to some word lines (e.g., WL<0>, WL<1>).

When a read voltage Vrd is provided to memory cells programmed with the dummy pattern DP, the corresponding memory cells may operate as off-cells. Therefore, it is possible to reduce word line loading during the initialization data read IDR operation or the replica read operation for the replica string.

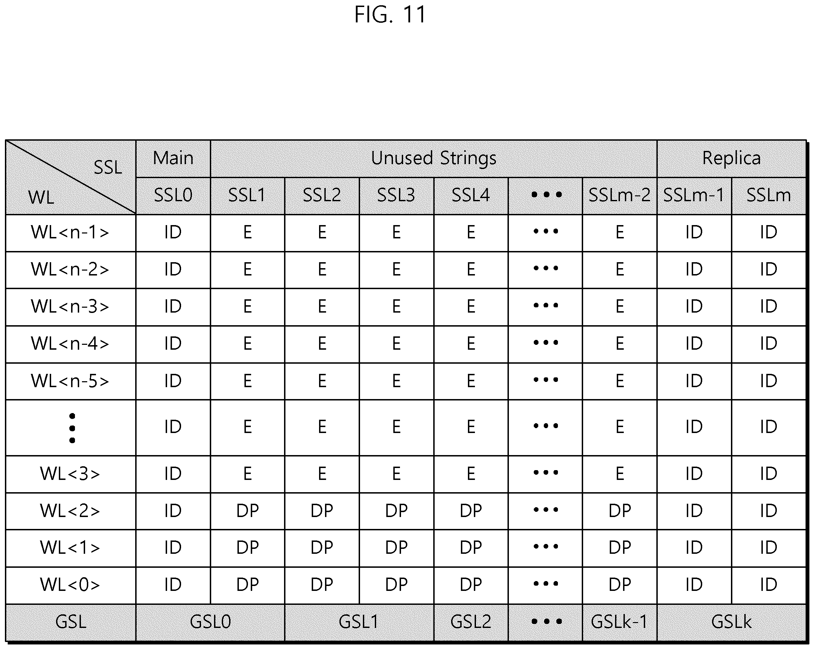

FIG. 11 is a table showing another example of a method of programming a dummy pattern DP for an unused area of an initialization data block ID_BLK. Referring to FIG. 11, initialization data ID may be stored in memory cells of the main string and replica string, and a dummy pattern DP may be programmed in some of the memory cells of the unused strings. At this time, the dummy pattern DP can be programmed only to memory cells connected to some word lines (e.g., WL<0>, WL<1>, and WL<2>). The range of memory cells in which the dummy pattern DP is programmed may be expanded to three or more word lines.

When the read voltage Vrd is provided to memory cells programmed with the dummy pattern DP, the corresponding memory cells may operate as off-cells. Therefore, it is possible to reduce word line loading during an initialization data read IDR operation or a replica read operation for a replica string. For example, when the NAND cell strings corresponding to the two string selection lines (SSLm-1, SSLm) are used as replica strings, the reliability of the initialization data ID can be increased.

In the table shown, an example in which NAND cell strings corresponding to two string selection lines SSLm-1 and SSLm are used as replica strings is illustrated. However, in some implementations, in order to increase the reliability of initialization data ID, NAND cell strings connected to 'n' or more ('n' is a natural number of 3 or more) string selection lines are used as replica strings. In this case, the reliability of the initialization data ID increases, but the time required for the initialization data read IDR operation may increase, and the effect of reducing power consumption or current peak may be reduced. In other words, there may be a trade-off relationship between the reliability of initialization data ID and the effect of reducing power consumption/current peaks. Considering these trade-offs, the number of string selection lines corresponding to the replica string may be determined.

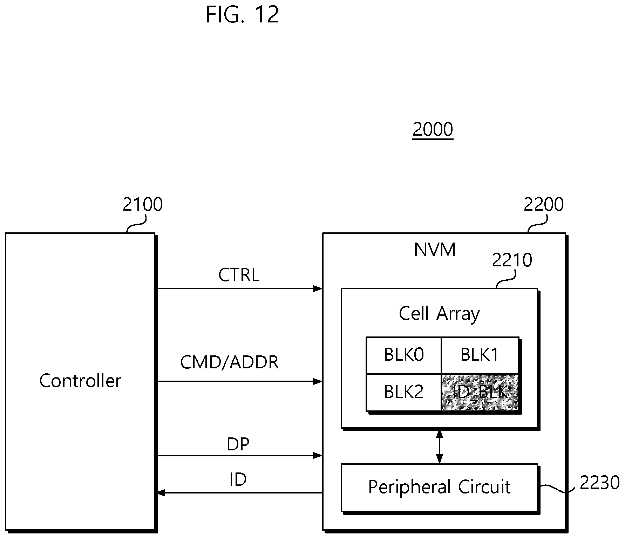

FIG. 12 is a block diagram showing a memory system that programs a dummy pattern DP and performs an initialization data read IDR operation. Referring to FIG. 12, the memory system 2000 may include a controller 2100 and a non-volatile memory device 2200.

The controller 2100 may be provided as a device or equipment that programs a dummy pattern DP in the non-volatile memory device 2200. During the production process of the non-volatile memory device 2200, the controller 2100 may program the dummy pattern DP in an unused area of the initialization data block ID_BLK. Alternatively, the controller 2100 may be connected to the memory controller of the non-volatile memory device 2200 and perform an initialization data read IDR operation to initialize the non-volatile memory device 2200. Through the initialization data read IDR operation, the controller 2100 may obtain initialization data ID from the initialization data block ID_BLK of the nonvolatile memory device 2200. And based on the acquired initialization data ID, the controller 2100 may initialize the operating conditions of the nonvolatile memory device 2200.

The nonvolatile memory device 2200 has the initialization data block ID_BLK described in FIGS. 1 to 11. The cell array 2210 includes the initialization data block ID_BLK, and initialization data ID is programmed in an initialization data area of the initialization data block ID_BLK. In addition, the dummy pattern DP may be programmed in the unused area of the initialization data block ID_BLK. Based on the dummy pattern DP program, it is possible to reduce the peak current and power consumption that occur during the initialization data read IDR operation. A peripheral circuit 2230 may include a row decoder 1200, page buffer circuit 1300, control circuit 1400, and voltage generator 1500 described in FIG. 1.

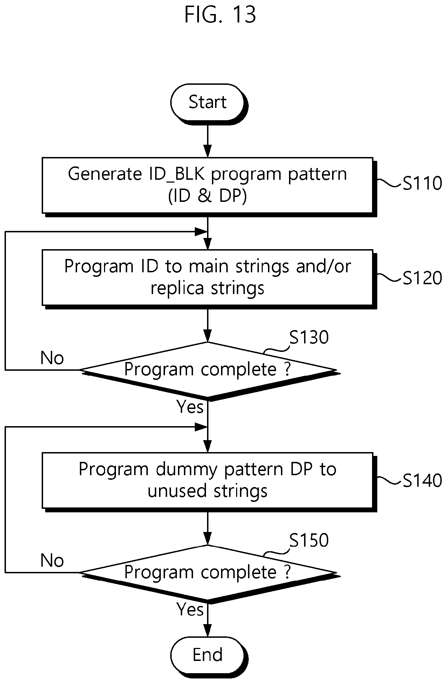

FIG. 13 is a flowchart showing an example of a programming procedure for initialization data and dummy patterns performed in the memory system of FIG. 12. Referring to FIG. 13, the controller 2100 can suppress word line loading during an initialization data read IDR operation by programming a dummy pattern DP in memory cells included in unused strings.

In step S110, the controller 2100 generates initialization data ID and a dummy pattern DP for programming the initialization data block ID_BLK. At this time, the dummy pattern DP can be created as a data pattern that can reduce channel charge inflow and word line loading that occur in the NAND cell string in the unused area during the initialization data read IDR operation. For example, a dummy pattern DP shown in FIGS. 9 to 11 may be generated.

In step S120, the controller 2100 programs initialization data ID into the memory cells of the main strings. When applying a replica string, the same initialization data ID programmed in the main strings will also be programmed in the memory cells of the replica strings.

In step S130, the controller 2100 checks whether the program of initialization data ID was successful. If the program of the initialization data ID is successful ('Yes' direction), the procedure moves to step S140. On the other hand, if the programming of the initialization data ID fails ('No' direction), the procedure returns to step S120 for reprogramming the initialization data ID.

In step S140, the controller 2100 programs the dummy pattern DP into memory cells of unused strings. The dummy pattern DP may be programmed in all memory cells of unused strings or in some memory cells.

In step S150, the controller 2100 checks whether the dummy pattern DP program was successful. If the dummy pattern DP program is successful ('Yes' direction), the overall initialization data block ID_BLK programming procedure is completed. On the other hand, if the programming of the dummy pattern DP fails ('No' direction), the procedure returns to step S 140 and a reprogramming procedure of the dummy pattern DP can be performed.

In the above, the dummy pattern DP programming method of the initialization data block ID_BLK has been briefly described.

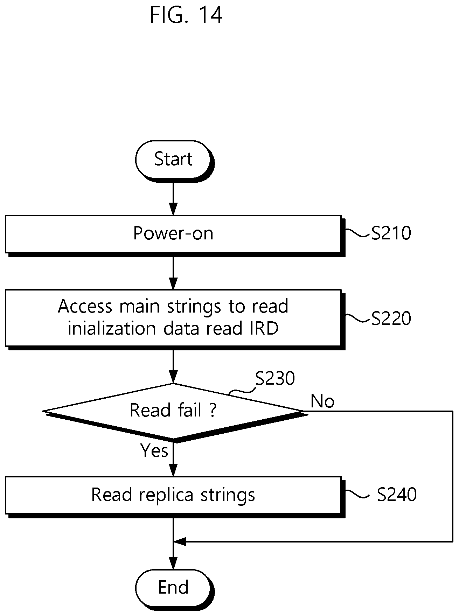

FIG. 14 is a flowchart showing an initialization data read IDR method in the memory system of FIG. 12. Referring to FIG. 14, the controller 2100 may perform an initialization data read IDR operation and initialize the non-volatile memory device 2200 using the result. At this time, the memory system 2000 may be a storage device such as a solid state drive SSD.

In step S210, power is provided to the nonvolatile memory device 2200. As another example, initialization may begin by resetting the nonvolatile memory device 2200. At this time, the controller 2100 performs various hardware reset operations such as power-on reset POR, hardware reset, and endpoint reset to set the nonvolatile memory device 2200 to a default state before initialization.

In step S220, the controller 2100 performs the initialization data read IDR operation to read the initialization data ID stored in the initialization data block ID_BLK of the non-volatile memory device 2200. The controller 2100 accesses the initialization data area of the initialization data block ID_BLK and reads the initialization data ID. For example, the controller 2100 reads data stored in the main strings of the initialization data area. At this time, the memory cells of unused strings in the unused area are programmed with the dummy pattern DP. Accordingly, during an initialization data read IDR operation, charge inflow into channels of unused strings or word line loading may be blocked.

In step S230, the controller 2100 checks whether the initialization data read IDR operation has failed. If the attempt to read the main strings of the initialization data area fails ('Yes' direction), the procedure moves to step S240. On the other hand, if the attempt to read the main strings of the initialization data area is successful ('No' direction), all initialization data read IDR procedures of the non-volatile memory device 2200 are terminated.

In step S240, the controller 2100 reads replica strings that store the same initialization data ID as the main strings. When the read operation for the replica strings is completed, all initialization data read IDR procedures of the non-volatile memory device 2200 are completed.

Based on the initialization data read IDR operation, peak current or word line loading in the unused area within the initialization data block ID_BLK of the nonvolatile memory device 2200 can be reduced.

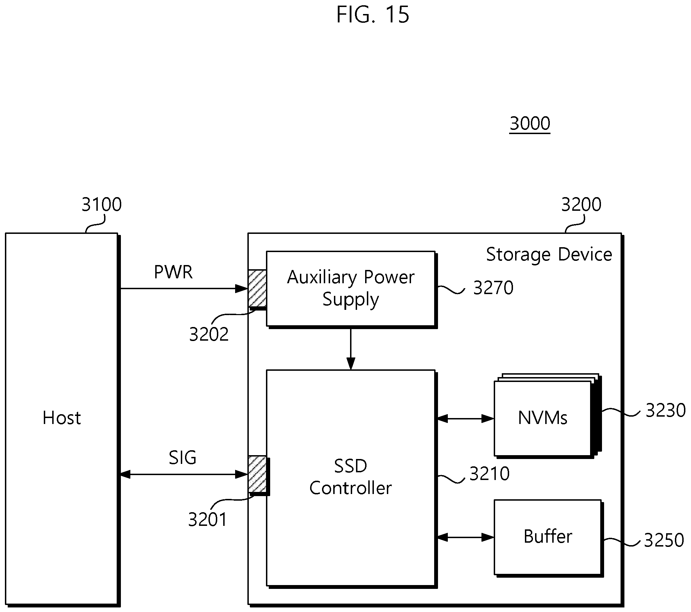

FIG. 15 is a block diagram showing a storage system including the non-volatile memory devices described herein. Referring to FIG. 15, the storage system 3000 includes a host 3100 and a storage device 3200 implemented as a solid state drive. The storage device 3200 may include a plurality of nonvolatile memory devices 3230, which can be the nonvolatile memory devices described with reference to FIGS. 1 to 14.

The storage device 3200 exchanges signals SIG with the host 3100 through the signal connector 3201 and receives power PWR through the power connector 3202. The storage device 3200 includes an SSD controller 3210, a plurality of non-volatile memories 3230, a buffer memory 3240, and an auxiliary power supply 3270.

The SSD controller 3210 may control a plurality of non-volatile memories 3230 in response to a signal SIG received from the host 3100. The plurality of non-volatile memories 3230 may operate under the control of the SSD controller 3210. The auxiliary power device 3270 is connected to the host 3100 through the power connector 3202. The auxiliary power device 3270 can receive power PWR from the host 3100 and charge it. The auxiliary power device 3270 may provide power to the storage device 3200 when power supply from the host 3100 is not smooth. The buffer memory 3250 may be used as a buffer memory of the storage device 3200.

In some implementations, each of the plurality of non-volatile memories 3230 includes an initialization data block ID_BLK for storing initialization data ID. Additionally, a dummy pattern DP is programmed in unused memory cells for which no initialization data of the initialization data block ID_BLK exists. Accordingly, during an initialization data read IDR operation of the non-volatile memories 3230, word line loading or channel charge inflow of NAND cell strings in the unused area can be reduced. Reduced word line loading and channel charge influx ensures a reduction in power consumption and peak current occurring during the initialization data read IDR operation.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While the present disclosure has been described with reference to various examples, it will be apparent to those of ordinary skill in the art that various changes and modifications may be made thereto without departing from the scope of the present disclosure as set forth in the following claims.

## Claims

1. A method of setting an initialization data block (ID_BLK) of a non-volatile memory device, comprising:
generating initialization data and a dummy pattern to be programmed into the initialization data block (ID_BLK);
programming the initialization data for initializing the non-volatile memory device into first memory cells of one or more first NAND cell strings (NS1-NS3) in an initialization data area of the initialization data block (ID_BLK); and
programming the dummy pattern in second memory cells of one or more second NAND cell strings (NS11-NS13, NS21-NS23, NS31-NS33, NS41-NSm1) in an unused area of the initialization data block (ID_BLK),
wherein the dummy pattern is configured such that the second memory cells programmed with the dummy pattern are turned off by a read voltage provided to the initialization data block (ID_BLK).

2. The method of claim 1, wherein the dummy pattern is programmed in all memory cells of the one or more second NAND cell strings (NS11-NS13, NS21-NS23, NS31-NS33, NS41-NSm1).

3. The method of claim 1 or 2, wherein the dummy pattern is programmed in memory cells, in the one or more second NAND cell strings (NS11-NS13, NS21-NS23, NS31-NS33, NS41-NSm1), connected to at least two word lines adjacent to each other.

4. The method of claim 3, wherein one of the at least two word lines is adjacent to a ground selection line (GSL1, GSL2).

5. The method of any one of claims 1 to 4, wherein the dummy pattern corresponds to a highest program state among program states of memory cells of the one or more second NAND cell strings (NS11-NS13, NS21-NS23, NS31-NS33, NS41-NSm1).

6. The method of any one of claims 1 to 5, wherein the one or more first NAND cell strings (NS1-NS3) comprise a plurality of first NAND cell strings that are connected to different bit lines (BLO, BL1, BL2) and wherein the plurality of first NAND cell strings (NS1-NS3) are connected to a common first string selection line (SSLO).

7. The method of any one of claims 1 to 6, further comprising:
programming the initialization data into one or more third NAND cell strings (NSx) in a replica area of the initialization data block (ID_BLK).

8. The method of any one of claims 1 to 7, wherein at least one of the one or more first NAND cell strings (NS1-NS3) shares a ground selection line (GSLO) with at least one of the one or more second NAND cell strings (NS11-NS13, NS21-NS23, NS31-NS33, NS41-NSm1).

9. A non-volatile memory device (1000) having an initialization data block (ID_BLK), the non-volatile memory device (1000) comprising:
a plurality of main strings (NS1-NS3), each main string connected to a different bit line (BLO, BL1, BL2) by a first string selection line (SSLO); and
a plurality of unused strings (NS11-NS13, NS21-NS23, NS31-NS33, NS41-NSm1) connected to the different bit lines (BLO, BL1, BL2) by a second string selection line (SSL1-SSL3, SSL4-SSLm-1),
wherein initialization data of the non-volatile memory device (1000) is stored in first memory cells of the plurality of main strings (NS1-NS3), and a dummy pattern is programmed in second memory cells of the plurality of unused strings (NS11-NS13, NS21-NS23, NS31-NS33, NS41-NSm1),
wherein the dummy pattern is configured such that the second memory cells of the plurality of unused strings (NS11-NS13, NS21-NS23, NS31-NS33, NS41-NSm1) are turned off by a read voltage provided to the initialization data block (ID_BLK).

10. The non-volatile memory device (1000) of claim 9, wherein the dummy pattern is programmed in all memory cells of the plurality of unused strings (NS11-NS13, NS21-NS23, NS31-NS33, NS41-NSm1).

11. The non-volatile memory device (1000) of claim 9 or 10, wherein the dummy pattern is programmed in memory cells, in the plurality of unused strings (NS11-NS13, NS21-NS23, NS31-NS33, NS41-NSm 1), connected to at least two adjacent word lines.

12. The non-volatile memory device (1000) of claim 11, wherein one of the at least two word lines is adjacent to a ground selection line (GSL1).

13. The non-volatile memory device (1000) of any one of claims 9 to 12, wherein the dummy pattern corresponds to a highest program state among program states of memory cells of the unused strings (NS11-NS13, NS21-NS23, NS31-NS33, NS41-NSm1).

14. The non-volatile memory device (1000) of any one of claims 9 to 13, wherein at least one of the plurality of unused strings (NS11-NS13, NS21-NS23, NS31-NS33, NS41-NSm1) shares a ground selection line (GSLO) with the plurality of main strings (NS1-NS3).

15. The non-volatile memory device (1000) of any one of claims 9 to 14, further comprising:
a plurality of replica strings (NSx) connected to the different bit lines (BLO, BL1, BL2) by a third string selection line (SSLm),
wherein third memory cells of the plurality of replica strings (NSx) are programmed with the initialization data stored in the first memory cells of the plurality of main strings (NS 1-NS3).
